# EUROPEAN PATENT APPLICATION

(11) **EP 2 804 274 A1**
(43) Date of publication of application: **19.11.2014**
(21) Application number: 13168026.6
(22) Date of filing: 16.05.2013
(51) Int. Cl.: H02B 13/065, G01R 31/12

(54) **Method for installing and method for uninstalling a sensor for detecting partial discharges in fluid insulated apparatuses and sensor for carrying out the methods**

(71) Applicant: ABB Schweiz AG, 5400 Baden (CH)
(72) Inventor: Behrmann, Glenn, 5400 Baden (CH)
(74) Representative: ABB Patent Attorneys

(57) **Abstract**

The invention relates to a method for installing a sensor (3) for detecting partial discharges in fluid insulated high-voltage and/or medium voltage apparatuses (1), wherein the sensor (3) comprises a supporting shaft (3d) and an antenna element, wherein the antenna element comprises a plurality of struts (3b), each having a first and a second end, each strut being attached at the first end to the supporting shaft (3d). Furthermore the invention relates to a method for uninstalling such a sensor (3). In a third aspect the invention concerns such a sensor (3).

## Description

### Background

The invention relates to the field of medium and high voltage switching technologies and concerns a method for installing a sensor for detecting partial discharges in fluid insulated apparatuses, a method for uninstalling a sensor, a sensor for detecting partial discharges and a fluid insulated apparatus with such a sensor, according to the independent claims.

### Prior Art

Fluid insulated apparatuses, like gas insulated switchgear or oil-filled transformers, are well known in the field of medium and high voltage switching applications. They are e.g. used for interrupting a current when an electrical fault occurs. For the purposes of this disclosure the term medium voltage refers to voltages from 1 kV to 72.5 kV and the term high voltage refers to voltages higher than 72.5 kV. Gas insulated switchgear, e.g. circuit breakers, may be required to carry high nominal currents up to 6300 A and to switch very high short circuit currents from 63 kA to 80 kA at very high voltages from 150 kV to 1200 kV.

Gas insulated switchgear, herewith also known as GIS, comprises at least two conductors which are insulated from one another by means of a fluid, which in many cases is an insulating gas. A well-known phenomenon occurring in GIS is called partial discharge. A partial discharge (PD) is an electrical discharge that occurs across a portion of the insulation between two conductors without causing a total breakdown or flashover between the two conductors. Partial discharges are caused when there is an inhomogeneity or defect in the insulation layer or material. Partial discharges can occur in solid insulation, e.g. polyethylene or silicone rubber, along the interfaces of multi-layer solid insulation systems, in gas bubbles in liquid insulation, around an electrode in a gas (also known as corona discharge), or in the case of conductive contaminants within the GIS, i.e. moving or fixed conductive or partially conductive particles. Partial discharges can initiate under normal working conditions in high voltage equipment where the insulation condition has deteriorated with age, has been aged prematurely by thermal or electrical over-stressing or due to improper installation or a combination of these and other factors. In the following an area within the insulation system which produces such characteristic PD signals will in general be known as a 'defect' in general. Partial discharges occur in the form of current pulses mainly confined within the defect and whose rise times are very short (typically < 1 nanosecond) depending on complex factors such as e.g. the pressure and composition of the gas within the defects in which they take place and which normally cannot be changed.

The partial discharge pulses generate radio frequency (RF) signals whose maximum frequency components extend up to several Gigahertz (VHF, UHF). The ranges of very high frequency (VHF) and of ultra high frequency (UHF) are assumed to be the ones defined by the International Telecommunication Union (ITU). Accordingly, they range from 30 to 300 MHz and 300 MHz to 3 GHz respectively.

The radio frequency signals propagate away from the defect(s) during which time they undergo severe reflection, dispersion and damping effects via a plurality of mechanisms and paths which inherently result from the construction of the GIS and which cannot be changed, such that the higher the frequency of the signals, the stronger is the degradation due to these damping and dispersive effects.

Partial discharges can cause degradation of the insulation by producing changes in the insulating qualities of adjacent materials or surfaces, often leading to further partial discharge activity, aging effects and overall deterioration of the insulating layers, with the result that breakdown or flashovers may occur once PD has initiated. Different types of insulation defects produce PD signals whose characteristics often allow the type of defect and or its location to be determined.

It is therefore important to avoid partial discharges and it is advantageous to detect them in order determine the defect type and to mitigate their effects.

In addition, the PD signals comprise high frequency components in excess of 1 GHz as previously described and, since the GIS is almost entirely enclosed by a metallic enclosure, said enclosure acts as a Faraday cage, thus containing the large part of the PD signals' energy and making their detection from outside of the metallic enclosure of the GIS difficult. Not only is it difficult to detect the typically low-amplitude PD signals from outside of the metallic enclosure, but also any external signals present in the same VHF and UHF frequency regions, e.g. mobile telephony, radar, Wi-Fi, etc, will interfere with and act to degrade the ability to detect the typically weak PD signals from outside the GIS metallic enclosure. Thus it is typical state of the art to utilize various e.g. electric field sensors enclosed within the metallic enclosure of the GIS to detect the high frequency PD signals while profiting from the shielding effects of the metallic enclosure.

EP 0 706 056 B1 discloses a sensor for detecting partial discharge impulses in high voltage equipment. The sensor is mounted in a cavity in an inner wall of the GIS, that is to say, within the metallic enclosure.

A drawback of such a solution is that the sensor must be incorporated into the design and construction of the GIS in the manufacturing phase and during its assembly.

### Description of the invention

It is therefore an objective of the invention to provide a possibility of carrying out partial discharge measurements inside a fluid insulated apparatus even when the respective fluid insulated apparatus doesn't already include a sensor of the type mentioned above.

In a first aspect of the invention the objective is solved by the features of claim 1 by a method for installing a sensor for detecting partial discharges in a fluid insulated high-voltage and/or medium voltage apparatus. The sensor comprises a supporting shaft and an antenna element. The antenna element comprises a plurality of struts, each having a first and a second end, and each strut being attached at the first end to the supporting shaft.

The method comprises the steps of evacuating an insulating fluid from the interior of the fluid insulated apparatus, exposing or opening an opening in an enclosure of the fluid insulated apparatus, particularly by removing an observation window of the fluid insulated apparatus, retracting the struts of the antenna element into a retracted position by moving the second ends of the struts towards the supporting shaft, inserting the antenna element in the retracted position through an opening of a sensor flange (i.e. sensor flange opening) of the sensor, inserting the sensor flange with the antenna element into the opening and attaching it to the enclosure or to a flange of the enclosure of the fluid insulated apparatus, pushing the antenna element into the opening at least up to a first predefined depth, the first predefined depth being chosen in such a way that the struts are entirely inserted into the fluid insulated apparatus, and stretching and extending the struts, inside the fluid insulated apparatus, from the retracted position into an extended position by moving the second ends of the struts away from the supporting shaft.

In this way a conductive surface is presented within the metallic enclosure of the fluid insulated apparatus which is connected via the conductive shaft to the outside via the insulated flange assembly attached to the metallic enclosure of the fluid insulated apparatus.

Advantageously, the method for installing the sensor further comprises the step of pulling the antenna element, in the extended position of the struts, towards the enclosure of the fluid insulated apparatus up to a second predefined depth. In this way it is possible to adjust the position of the antenna element inside the fluid insulated apparatus in such a way that the extended struts are located as far as possible from a center conductor of the fluid insulated apparatus while still maintaining separation from the inner wall of the metallic enclosure so as not to form a short circuit between the struts of the sensor and the metallic enclosure. This measure minimizes the risk of flashovers from the center conductor to the sensor by increasing the distance between said center conductor and the antenna element while still maintaining separation and isolation of the sensor from the grounded metallic enclosure, thus allowing it to capacitively couple the electric field of VHF and UHF signals caused by partial discharges to the outside of the metallic enclosure of the GIS.

Advantageously, the method for installing the sensor further comprises the step of connecting a coaxial radio-frequency connector (RF coaxial connector) to the sensor supporting shaft by means of a center pin of the coaxial connector. The RF coaxial connector is attached to a connector carrier which is in turn attached to the sensor flange. By this means the high frequency PD signals picked up inside the GIS enclosure by the sensor are conveyed via the sensor support shaft and the coaxial RF connector to the outside of the fluid insulated apparatus where they can be analysed, e.g. by means of a spectrum analyser, oscilloscope, partial discharge analyser, or other suitable apparatus.

In one preferred embodiment of the invention a conductive film or fabric is connected to the struts. The film or fabric has at least an electrically conductive layer electrically connected to the supporting shaft and is stretchable into an extended position by moving the second ends of the struts away from the shaft and is shrinkable into a retracted position by moving the second ends of the struts towards the supporting shaft.

Advantageously, the step of stretching the struts from its retracted position into its extended position is carried out in such a way that a removable holder element of the sensor is removed and the struts resile and thereby stretch the film into the extended position.

In another advantageous embodiment the step of stretching the struts from their retracted position into the extended position is carried out by actuating e.g. a runner or a sleeve to slide in such a way that the outside or second ends of the struts are pivoted away radially from the supporting shaft.

In a second aspect of the invention the objective is solved by a method for uninstalling a sensor for detecting partial discharges in a fluid insulated high voltage and/or medium voltage apparatus, wherein the sensor was previously installed into the fluid insulated apparatus by the method according to the invention. The method for uninstalling the sensor comprises the steps of evacuating an insulating fluid from the interior of the fluid insulated apparatus, retracting the struts from the extended position into the retracted position, detaching the sensor flange from the enclosure or from the flange of the enclosure of the fluid insulated apparatus and pulling it out through the opening of the fluid insulated apparatus at least together with the supporting shaft and the struts, and hermetically closing the opening of the fluid insulated apparatus with a sealing element, particularly with an observation window or a gas-handling fixture or another sealing element.

Advantageously, the step of retracting the struts from the extended position into the retracted position is carried out by first pushing the supporting shaft into the opening at least up to the first predefined depth and subsequently actuating a runner or a sleeve of the sensor to slide in such a way on the supporting shaft that the outside or second ends of the struts are pivoted radially back towards the shaft.

An alternative is to carry out the step of retracting the struts from the stretched position into the retracted position during the step of detaching the sensor flange from the enclosure or from the flange of the enclosure of the fluid insulated apparatus and pulling it out through the opening of the fluid insulated apparatus at least together with the supporting shaft and the struts. This can be done in such a way that while detaching the sensor flange the second end of the struts fold over the supporting shaft, wherein the struts point towards the inside of the fluid insulated apparatus, along the longitudinal axis of the supporting shaft.

According to a third aspect of the invention a sensor for detecting partial discharges in fluid insulated apparatuses when it is installed in the latter is provided. The sensor comprises a supporting shaft, a sensor flange and an antenna element. The antenna element comprises a plurality of struts, each of which has a first end and a second end and is attached at the first end to the supporting shaft.

The sensor according to the third aspect of the invention is preferably used in fluid insulated switchgear, particularly gas insulated switchgear, or oil insulated transformers.

By providing a sensor of the type described above, installed by following the steps of the method according to the first aspect of the invention, it is possible to carry out partial discharge measurements in already existing GIS with minimal efforts. For example, the sensor can be introduced into the existing GIS via an already present opening in the metallic enclosure of the latter, e.g. an observation window or other sealed cover. Hence it is not necessary to drill or bore an opening through the enclosure of the GIS in order to introduce the sensor therein. This advantage is particularly due to the capability of the sensor of being expandable and retractable. The former capability allows the electrical size of the sensor antenna element to be expanded within the GIS enclosure and thus increase its sensitivity to the PD signals, while the latter capability allows insertion of the sensor antenna element through only a relatively small, already present opening in the enclosure of the GIS. As the sensor is removable by following the steps of uninstalling it according to the second aspect of the invention, the GIS can be brought back to its initial configuration after the removal of the sensor. Thus, a GIS doesn't have to be initially provided with a sensor for measuring partial discharges, but a sensor according to the third aspect of the invention may be used when required, i.e. when the age of the GIS or other factors suggest partial discharge activity may be present and thus advantageously may be measured using such a sensor.

### Short description of the drawings

Further embodiments, advantages and applications of the invention result from the dependent claims and from the following description by means of the figures. It is shown in:
Fig. 1 a sectional view of a simplified basic embodiment of a GIS with a first embodiment of the sensor according to the third aspect of the invention;
Fig. 2 a top view of an antenna element of the sensor of Fig. 1 as seen in the direction of the longitudinal axis x;
Fig. 3 a detailed sectional view of the sensor of Fig. 1 with struts of the antenna element in a retracted position;
Fig. 4 a detailed sectional view of the sensor of Fig. 1 with the struts of the antenna element in an extended position;
Fig. 5 a detailed sectional view of a second embodiment of the sensor according to the invention with the struts in an extended position;
Fig. 6 a side view of an antenna element according to a third embodiment of the sensor of Fig. 1 with the struts in a retracted position; and
Fig. 7 a side view of the antenna element according to the third embodiment of the sensor with the struts in an extended position.

### Ways of carrying out the invention

In the following description the same reference numerals are used to denote structurally or functionally the same or similar elements of the various embodiments of the invention.

In the following examples the fluid insulated apparatus is represented by gas insulated switchgear (GIS), e.g. a circuit breaker. Another example for a fluid insulated apparatus is an oil insulated transformer.

Based on signal wavelengths at which a sensor according to the invention would preferably be applied, along with typical dimensions of the GIS, it is understood that the antenna element is operating in the near field, i.e. at distances typically less than ten wavelengths.

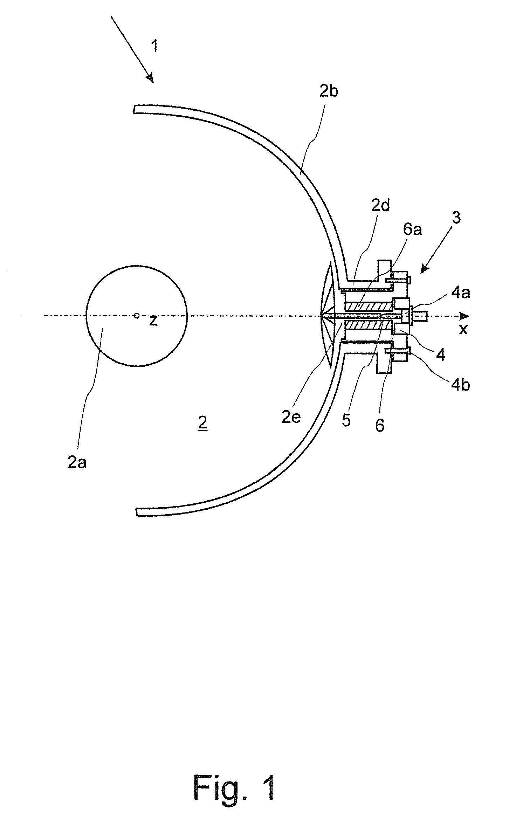

Fig. 1 shows a sectional view of a simplified basic embodiment of a gas insulated switchgear 1 with a first embodiment of the sensor 3 according to the invention. The GIS 1 is shown in a very simplified manner, only a part of its enclosure 2b and its inner conductor 2a being shown in a radial sectional view, parallel to the axis z. The sensor 3 is also shown in a sectional view, however in a longitudinal sectional view with respect to its longitudinal axis x.

It is assumed that an insulating fluid 2 is present in the interior of the GIS 1 prior to installing the sensor 3. The insulating fluid 2 is first evacuated in step a) of the method for installing the sensor 3 and is refilled after the installation. Thus, the installation step g) or h) of the method for installing the sensor 3 are carried out before the interior of the GIS 1 is refilled with the insulating fluid 2. In one embodiment of the sensor 3 it is sufficient to carry out step g) of the method for installing the sensor 3 in order to ensure a gas-tight sealing of the interior of the GIS 1, if the sensor 3 comprises suitable elements (not shown) for gas-tight sealing. In another embodiment it is necessary to carry out step h) of the method for installing the sensor 3. In this embodiment a gas-tight connector 4a is used to couple to the antenna element of the sensor 3. Hence, the gas-tight connection is only present after the connector 4a has been installed. In the embodiments of the invention described herein the second alternative is assumed.

For the purposes of this disclosure the fluid used in the gas insulated switchgear can be or comprise SF₆ gas or any other dielectric insulation medium such as fluoroketone with any carrier gas (e.g. air, nitrogen, carbon dioxide, mixtures thereof), may it be gaseous and/or liquid, and in particular can be a dielectric insulation gas or arc quenching gas.

The coaxial radio frequency (RF) connector 4a is connected to the antenna element of the sensor 3 by means of its center pin 5, which can be of types known to the person skilled in high frequency connectors. In a preferred embodiment the connector 4a is a gas-tight type N RF-connector, for example a type N connector is a threaded RF-connector capable of carrying radio frequency signals and is known to the skilled person.

As can be seen in the Figure 1, the GIS 1 has an opening 2e through the enclosure 2b through which the antenna element of the sensor 3 may be inserted into the interior of the GIS 1. Around the opening 2e there is a GIS flange 2d which serves for holding a sealing element which is not shown in Fig. 1. The sealing element may e.g. be an observation window or a blank cover for other purpose, which was provided for the GIS 1 during its assembly. The sensor 3 comprises a sensor flange 6 which is inserted into the opening 2e through the GIS flange 2d. In Fig. 1 the sensor flange 6 is shown to be inserted into the opening just up to an inner wall of the enclosure 2b. The sensor flange 6 may be screwed into the opening 2e if the GIS flange 2d is threaded, or it may be screwed onto the GIS flange 2d if appropriate screw openings are provided in the GIS flange 2d. In this example the sensor flange 6 is attached to the GIS flange 2d by means of bolts 4b. It is understood that any kind of suitable attachment means may be used for attaching the sensor flange 6 to the GIS flange 2d. By this, the sensor 3 is adaptable to any kind of attachment of the sealed element which was previously attached to the GIS flange 2d. It is furthermore understood that the sensor 3 is so equipped and adapted to the opening 2e and the associated flange 2d such that it is also a sealing element, so that once it is installed, the GIS 1 may be re-filled with the insulating fluid 2, the design of the sensor 3 being such that the insulating fluid will not leak out.

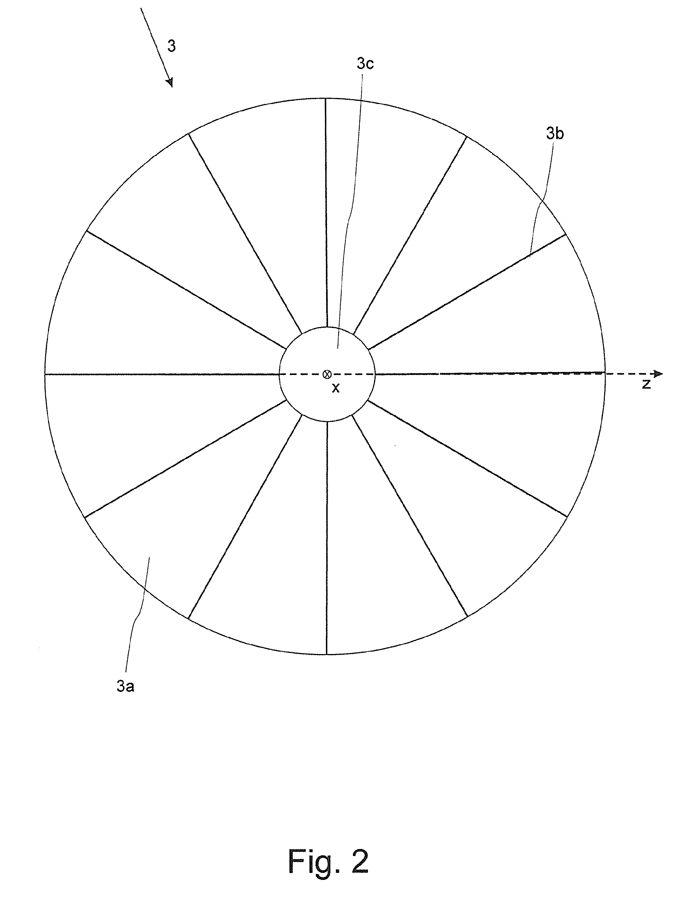

Fig. 2 shows a view of the antenna element of the sensor 3 of Fig. 1 as seen in the direction of the longitudinal axis x of the sensor 3. It comprises a flexible conductive film or fabric 3a attached to struts 3b which themselves are attached to a metallic center hub 3c. The flexible film 3a may also be attached to the center hub 3c, as the case may be.

Preferably, the struts 3b comprise or are made of poly-paraphenylene-terephthalamide, known as Kevlar. Advantageously, the usage of this material enhances the strength of the struts and at the same time acts to support the conductive film 3a in its extended or open position as shown in Fig 2.

The film 3a may advantageously comprise at least a layer of Kevlar or biaxially-oriented polyethylene-terephthalate, known as Mylar. Aluminized Mylar may also be used. In an advantageous embodiment the film 3a comprises two of said layers of poly-paraphenylene-terephthalamide and the electrically conductive layer mentioned at the beginning is arranged between the two layers.

Advantageously, the electrically conductive layer is electrically connected to a supporting shaft 3d (shown in Fig. 1 and 3 to 5) by means of the metallic center hub 3c arranged concentrically around the longitudinal axis x of the sensor 3. The struts 3b are preferably attached to the supporting shaft 3d by means of the center hub 3c.

In this embodiment, when the struts 3b are moved from the extended position shown in the figure into the retracted position, also the film or fabric 3a is retracted and vice versa.

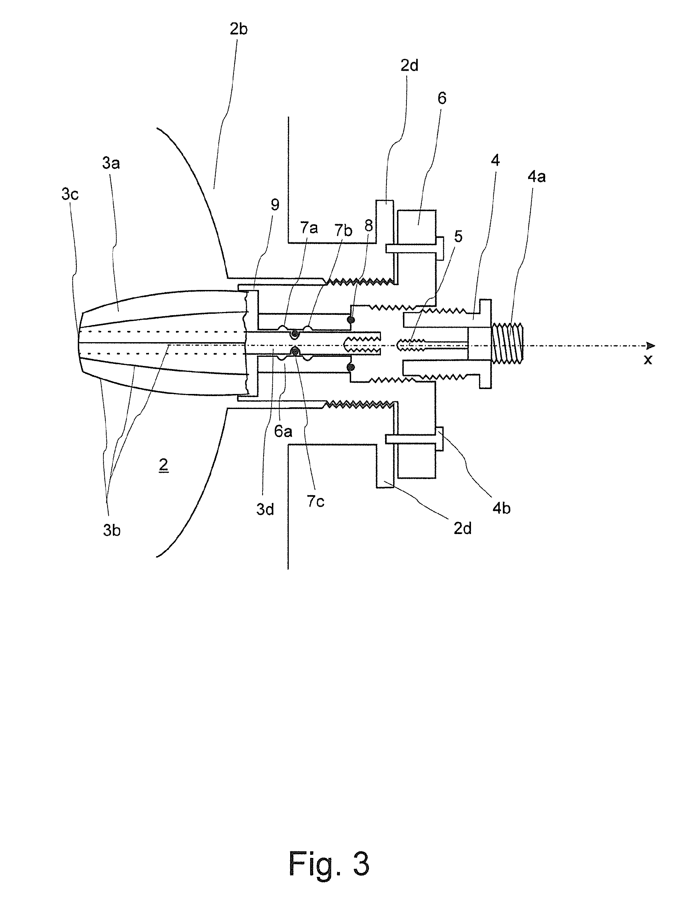

Fig. 3 shows a detailed sectional view of the sensor 3 of Fig. 1 with struts 3b of the antenna element in a retracted or closed position. Besides the antenna element the sensor 3 comprises the supporting shaft 3d which is made of or comprises electrically conductive material. The supporting shaft 3d is detachably attachable coaxially inside the sensor flange 6. The sensor flange 6 advantageously comprises an insulating sleeve 6a made of e.g. Teflon or polyethylene or other dielectric material which exhibits favourable characteristics for the transmission of RF signals. It is understood that the sensor flange 6 comprises electrically conductive material so that outer conducting housing of the RF coaxial connector 4a is electrically connected to the GIS enclosure 2b, and the insulating sleeve 6a is arranged in such a way that there is electrical insulation between the sensor 3, particularly its support shaft 3d, with respect to the GIS enclosure 2b.

The sensor 3 further comprises a connector carrier 4 which is mounted onto the sensor flange 6, in this example by screwing it onto the sensor flange 6. The sensor flange 6 itself is screwed onto the GIS flange 2d. It is understood that different means of attachment and sealing may advantageously be used. An RF coaxial connector 4a, for example an N type RF connector, is attached to the connector carrier 4 which is detachably attachable to the sensor flange 6 so as to ensure a gas-tight hermetic seal for preventing leakage of the insulating fluid 2. The RF coaxial connector 4a is electrically connectable to the supporting shaft 3d by means of the connector center pin 5 which may be inserted or screwed into a threaded bore of the supporting shaft 3d. The sensor 3 comprises at least one sealing element 8, in this example an O-ring, for providing the gas tight seal between the sensor flange 6 and/or the connector carrier 4 and/or the supporting shaft 3d. This is done by screwing the connector carrier 4 to such an extent into the sensor flange 6 that the O-Ring 8 is compressed and thereby seals the gaps between the connector carrier 4 and the sensor flange 6 in a gas tight manner.

During the procedure of screwing the connector carrier 4 into the sensor flange 6 also the connector center pin 5 is inserted or screwed into the corresponding bore of the supporting shaft 3d. In another embodiment it may be provided that the connector 4a is inserted and fixed to the supporting shaft 3d after the connector carrier 4 has been attached to the sensor flange 6.

By this arrangement it is possible to convey signals picked up by the antenna element 3 from within the interior of the GIS 1 via the supporting shaft 3d and the connector 4a to measurement instruments outside of the GIS.

In this embodiment the first ends of the struts 3b are rigidly attached to the center hub 3c. The sensor flange 6 comprises a cavity 9, which is preferably cylindrical, for retaining second or outside ends of the struts 3b tensioned inside the cavity 9 in the retracted position of the film 3a. Alternatively, the sensor 3 may comprise a holder element (not shown), particularly a band or a ring, for keeping the struts 3b tensioned in the retracted position of the film 3a. The holder element is removable for releasing the tensioned struts 3b which thereby snap outwards into the extended position of the conductive film 3a.

In the following the process of installing and uninstalling the sensor 3 into the GIS 1 is explained for this embodiment.

First, the insulating fluid 2 is evacuated from the interior of the gas insulated switchgear 1. Preferably, the gas 2 is sucked out and stored for later use or for refilling the GIS 1 after the partial discharge measurements have been carried out and the GIS 1 has been restored to its initial state. Thereafter, the opening 2e in the enclosure 2b of the gas insulated switchgear 1 is exposed. As mentioned, the opening 2e is provided for an observation window in this example. However, depending on the construction of the GIS 1 it is possible to use another opening in the enclosure of the GIS 1. After this step the conductive film 3a of the antenna element is retracted into a retracted position by moving the second or outside ends of the struts 3b towards the longitudinal axis x and the antenna element is inserted, in its retracted position, through the opening of the sensor flange 6. Subsequently, the sensor flange 6 of the sensor 3 is inserted into the opening 2e together with the antenna element and is attached to the flange 2d of the enclosure 2b of the gas insulated switchgear 1. Thereafter, the antenna element is pushed into the opening 2e at least up to a first predefined depth, the first predefined depth being chosen in such a way that the struts 3b are entirely inserted into the gas insulated switchgear 1. In Fig. 3 to 5 the first predefined depth is given by the position of a first recess 7a in the sensor flange 6. Finally, the conductive film 3a is stretched out inside the gas insulated switchgear 1, from the retracted position into its extended position, by moving the second or outside ends of the struts 3b away from the longitudinal axis x. In this embodiment the struts 3b, which are tensioned by having been bent with their second or outside ends into the cavity 9, are released from the cavity 9 when the supporting shaft 3d is pushed further into the GIS 1 and thereby resile, thus taking on the extended position shown in Fig. 2. It is clear that the distance of the stretched and extended film 3a from the enclosure 2b of the GIS 1 substantially corresponds to the length of the strut 3b. Depending on the configuration and the dimensions of the GIS 1 it may be necessary to retract the sensor away from the GIS inner conductor, towards the enclosure 2b of the GIS 1, up to a second predefined depth which is defined by the position of a second recess 7b in the sensor flange 6. By this it is avoided that the center hub 3c is located too close to the center conductor 2a of the GIS 1, thus minimizing the risk of experiencing flashovers from said conductor 2a to the center hub 3c. Now the RF-connector 4a of the sensor 3 is connected to the supporting shaft 3d and the connector carrier 4 carrying the RF-connector 4a is connected to the sensor flange 6.

After the sensor 3 has been installed, the insulating fluid 2 is refilled into the GIS 1. Finally, the GIS 1 is set into operation again and the partial discharge measurements can be initiated.

As noted above, the sensor flange 6 has a first and a second recess 7a, 7b. In the following their purpose will be explained. Generally, the supporting shaft 3d has at least a first positioning element cooperating with at least a second positioning element of the sensor flange 6 in order to define an insertion depth of the supporting shaft 3d into the sensor flange 6. One of the first or the second positioning element comprises at least one recess 7a, 7b at a second predefined depth and the other positioning element comprises an elastic member 7c snapping into the recess 7a, 7b at the second predefined depth in order to fix the antenna element with the conductive film 3a in its stretched out or extended position, that is in its final measurement position. In the present embodiment the first positioning element is the elastic member 7c and the second positioning element is the second recess 7b. The elastic element 7c may be a ball arranged in a recess of the supporting shaft 3d, which is pushed towards the outside of the shaft 3d by a spring (not shown). When the supporting shaft 3d glides along the through opening of the sensor flange 6 the ball 7c is positioned inside the shaft 3d until it reaches the second recess 7b. At this position it snaps into the second recess 7b, being actuated by said spring. By this means, the user notices that a key position has been reached. In order to move the supporting shaft 3d further into the through opening it is necessary to increase the pushing force just as much as to overcome the spring force acting on the ball 7c. By this, the ball 7c is pushed back into the recess of the supporting shaft 3d and the shaft 3d continues gliding along the through opening. Such a position of the ball 7c is illustrated in Fig. 3. This position shall emphasize that the supporting shaft 3d is in the process of being pushed towards the first recess 7a such that the film 3a can subsequently be stretched.

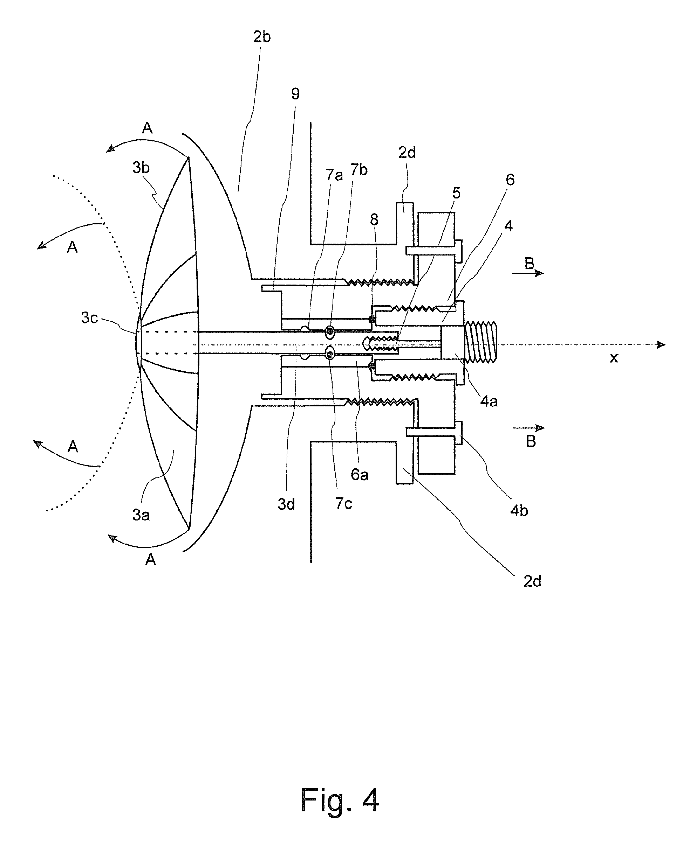

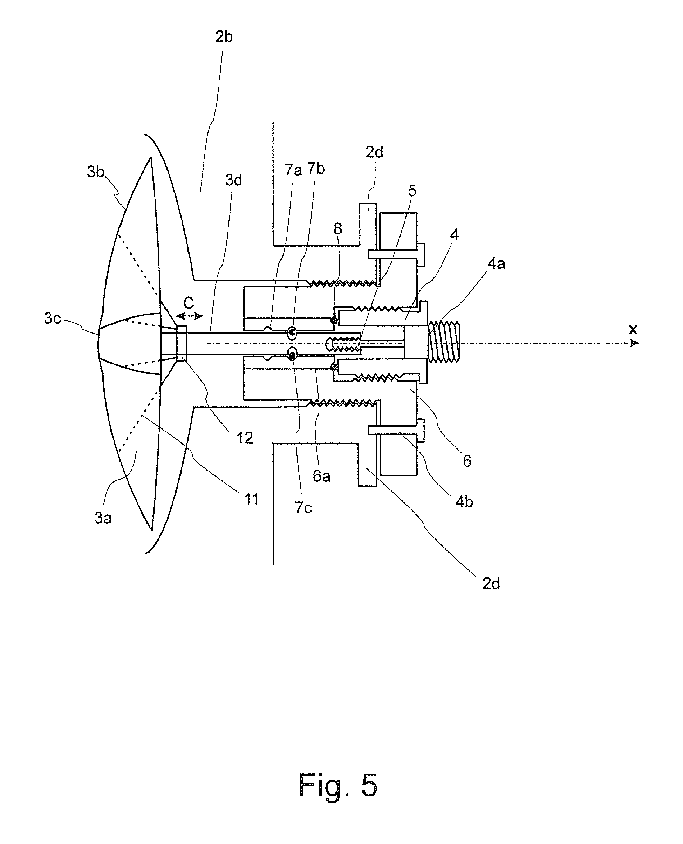

For Fig. 4 and 5 only the differences to Fig. 3 will be described.

Fig. 4 shows a detailed sectional view of the sensor 3 of Fig. 1 with the struts 3b of the antenna element in an extended position, according to the first embodiment of the sensor 3 described in connection with Fig. 3. In this figure the antenna element is shown in its final measurement position after the shaft 3d has been pushed up to the first predefined depth at the location of the first recess 7a, the film 3a has been stretched out and the shaft 3d has been pulled back into the position corresponding to the second predefined depth at the location of the second recess 7b, and just before being uninstalled. The arrows B and A indicate the movement of the sensor 3 and of the struts 3b during the uninstalling process. When the connector carrier 4 and the sensor flange 6 are being unscrewed, the second ends of the struts 3b will eventually touch the interior wall of the enclosure 2b of the GIS 1 and will be forced back, thus folding over the center hub 3c. This is illustrated by the arrows A. In this reversed position it is subsequently possible to pull the antenna element out of the opening 2e of the GIS 1.

The embodiment of the sensor 3 according to Fig. 3 and 4 has the advantage that the uninstalling process is simple, only requiring that the sensor 3 is pulled out of the opening 2e.

Fig. 5 shows a detailed sectional view of a second embodiment of the sensor 3 with the struts in an extended position. In this embodiment the sensor 3 comprises at least one tensioning element 11. The tensioning element 11 is attached to the struts 3b between their first or inward and their second or outside end, and is attached to the supporting shaft 3d by means of a runner or sleeve 12 which can be slid back and forth along the supporting shaft 3d. In other embodiments, an actuation element (not shown) is provided for sliding the runner or sleeve 12. The arrow C shows the sliding directions of the runner or sleeve 12 on the supporting shaft 3d. A structural difference to the embodiment of Fig. 3 and 4 is that no cavity 9 of the sensor flange 6 and no holder element are required in this embodiment.

When installing the sensor 3, basically the same procedure as in case of the embodiment of Fig. 3 and 4 is used, with some differences explained in the following. One difference is that the film 3a is retracted into the retracted position by sliding the runner or the sleeve 12 in the direction of the longitudinal axis x. With reference to the installing procedure described in conjunction with Fig. 3 and 4, also in this case the shaft 3d is pushed up to the first predefined depth in order to stretch the film 3a into its extended position. However, in this embodiment the conductive film 3a is stretched out by actuating the runner or the sleeve 12 in the insertion direction of the sensor 3. By this means, the tensioning elements 11 push the struts 3b away from the supporting shaft 3d until the conductive film 3a is fully stretched out and extended. Then the runner or the sleeve 12 is locked in the corresponding position. It shall be noted that in this embodiment the struts 3b are attached to the center hub 3c at their first ends in a way which allows them to pivot freely. After the film has been extended the antenna element is pulled back until the elastic element 7c snaps into the second recess 7b, as described in the case of the previous embodiment of the sensor 3.

When uninstalling the sensor 3, the shaft 3d is again pushed into the interior of the GIS 1 until the elastic element 7a snaps into the first recess 7a, this being a signal that the struts 3b can be actuated by the runner or the sleeve 12 via the tensioning elements 11 to fold back towards the supporting shaft 3d in order to retract the conductive film 3a into its retracted position. Thereafter the sensor can be entirely removed from the opening of the GIS 1.

The embodiment of the sensor 3 according to Fig. 5 has the advantage that the movement of the conductive film from its extended position into its retracted position and vice versa is done in a controlled way, thus not necessarily requiring a highly flexible and strong material for the struts 3b.

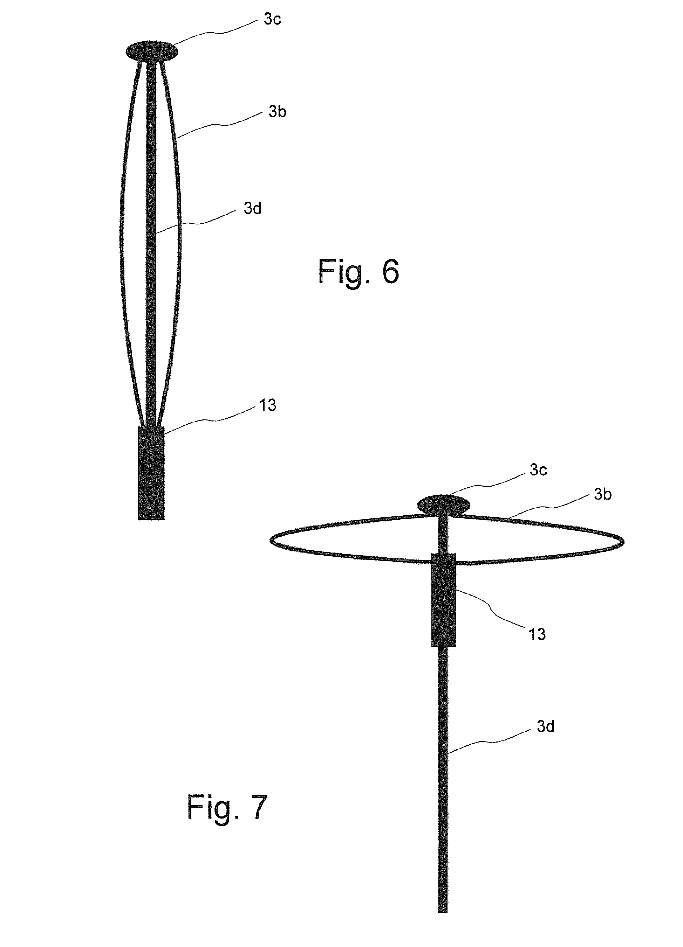

Fig. 6 shows a side view of an antenna element according to a third embodiment of the sensor 3 according to the invention with the struts 3b in a retracted position. One difference between the third embodiment of the sensor 3 and the previous embodiments is that the antenna element does not comprise a flexible conductive film or fabric. It is understood that this embodiment can also be used in conjunction with all other features and elements of the first or second embodiment of the sensor 3 which do not concern the conductive film or fabric. Another difference to the previous embodiments of the sensor 3 is that the second ends of the struts 3b are fixedly attached to a tensioning runner element 13 which is slidable along the supporting shaft 3d in the same way as the runner or sleeve 12 of the second embodiment of the sensor 3. In this figure the struts 3b are shown in the retracted position.

Fig. 7 shows a side view of the antenna element according to the third embodiment of the sensor 3 with the struts 3b in an extended position. In order to move the struts 3b into the extended position, the tensioning runner element 13 is slid towards the first ends of the struts 3b, that is towards the center hub 3c. Because of the attachment of the tensioning runner element 13 to the second ends of the struts 3b the latter are bent and open radially outwards from the supporting shaft 3d inside of the gas insulated switchgear 1, such that the plurality of all conductive struts form a 'disc'-shape. In this way a conductive virtual surface is presented within the metallic enclosure 2b of the GIS 1, which is connected via the conductive supporting shaft 3d to the outside, in the same way as for the previously described embodiments. It is understood that the tensioning runner element 13 and/or the supporting shaft 3d has/have locking element/elements (not shown) for keeping the struts in the extended position. This is required because the struts 3d, which are tensioned to a high degree in the extended position, tend to push the tensioning runner element 13 away from the center hub 3c. The locking elements may be actuated from the outside of the GIS 1 (not shown).

The sensor according to the invention is suitable to be used for measuring partial discharges in existing gas insulated switchgear, thus reducing the effort and expense of modifying and adapting such GIS in order to prepare them for said measurements. A further advantage of the solution according to the invention is that the sensor can be inserted farther into the Faraday cage of the GIS, thus allowing more sensitive measurements. A further advantage of the sensor is that it can be inserted in any compartment equipped with a flange opening, in order to e.g. facilitate more precise location of a PD defect within the GIS using time-of-flight measurements or other suitable well-known means.

While there are shown and described presently preferred embodiments of the invention, it is to be distinctly understood that the invention is not limited thereto but may otherwise variously be embodied and practised within the scope of the following claims. Therefore, terms like "preferred" or "preferably" or "in particular" or "particularly" or "advantageously" or the like signify optional and exemplary embodiments only.

**List of reference numerals**

| | |
|---|---|
| 1 | = fluid insulated apparatus |
| 2 | = insulating fluid |
| 2a | = inner conductor of GIS |
| 2b | = GIS enclosure |
| 2d | = GIS flange |
| 2e | = opening through the GIS enclosure |
| 3 | = PD sensor |
| 3a | = antenna element conductive film or fabric |
| 3b | = strut |
| 3c | = center hub |
| 3d | = supporting shaft |
| 4 | = radio frequency connector carrier |
| 4a | = radio frequency connector |
| 4b | = attachment bolt |
| 5 | = connector center pin |
| 6 | = sensor flange |
| 6a | = insulating sleeve |
| 7a | = recess at the first predefined depth |
| 7b | = recess at the second predefined depth |
| 7c | = elastic member |
| 8 | = O-ring |
| 9 | = cylindrical cavity |
| 11 | = tensioning element |
| 12 | = runner or sleeve |
| 13 | = tensioning runner element |
| A | = moving direction of struts |
| B | = removal direction of sensor |
| C | = moving direction of runner or sleeve or tensioning runner element |
| z | = GIS axis |
| x | = longitudinal sensor axis |

## Claims

1. Method for installing a sensor (3) for detecting partial discharges in a fluid insulated high voltage and/or medium voltage apparatus (1), wherein the sensor (3) comprises a supporting shaft (3d) and an antenna element, wherein the antenna element comprises a plurality of struts (3b), each having a first and a second end, each strut (3b) being attached at the first end to the supporting shaft (3d),
comprising the steps of:
a) evacuating an insulating fluid (2) from the interior of the fluid insulated apparatus (1),
b) exposing an opening (2e) in an enclosure (2b) of the fluid insulated apparatus (1), particularly by removing an observation window of the fluid insulated apparatus (1),
c) retracting the struts (3a) of the antenna element into a retracted position by moving the second ends of the struts (3b) towards the supporting shaft (3d),
d) inserting the antenna element in the retracted position through a sensor flange opening of a sensor flange (6) of the sensor (3),
e) inserting the sensor flange (6) with the antenna element into the opening (2e) and attaching it to the enclosure (2b) or to a flange (2d) of the enclosure (2b) of the fluid insulated apparatus (1),
f) pushing the antenna element into the opening (2e) at least up to a first predefined depth, the first predefined depth being chosen in such a way that the struts (3b) are entirely inserted into the fluid insulated apparatus (1), and
g) stretching and extending the struts (3b), inside the fluid insulated apparatus (1), from the retracted position into an extended position by moving the second ends of the struts (3b) away from the supporting shaft (3d).

2. Method according to claim 1, further comprising the step of:
h) pulling the antenna element, in the extended position of the struts (3b), towards the enclosure (2b) of the fluid insulated apparatus (1) up to a second predefined depth.

3. Method according to claim 1 or 2, further comprising the step of:
i) connecting a coaxial radio-frequency connector (4a) of the sensor (3) with the supporting shaft (3d) by means of a center pin (5) of the connector (4a) and attaching a connector carrier (4) which holds the coaxial radio-frequency connector (4a) to the sensor flange (6).

4. Method according to any one of the preceding claims, wherein step g) is carried out in such a way that a removable holder element is removed and the struts (3b) resile, thereby stretching the struts (3b) into their extended position.

5. Method according to any one of the claims 1 to 3, wherein step g) is carried out by actuating a runner or a sleeve (12) to slide in such a way that the second ends of the struts (3b) are pivoted away radially from the supporting shaft (3d).

6. Method for uninstalling a sensor (3) for detecting partial discharges in a fluid insulated high voltage and/or medium voltage apparatus (1), wherein the sensor (3) was previously installed into the fluid insulated apparatus (1) by the method according to any one of the claims 1 to 5, comprising the steps of:
a) evacuating an insulating fluid (2) from the interior of the fluid insulated apparatus (1),
b) retracting the struts (3b) from the extended position into the retracted position,
c) detaching the sensor flange (6) from the enclosure (2b) or the flange (2d) of the enclosure (2b) of the fluid insulated apparatus (1) and pulling it out through the opening (2e) in the enclosure (2b) of the fluid insulated apparatus (1) at least together with the supporting shaft (3d) and the struts (3b), and
d) hermetically closing the opening (2e) in the enclosure (2b) of the fluid insulated apparatus (1) with a sealing element, particularly with an observation window.

7. Method according to claim 6, wherein step b) is carried out by first pushing the supporting shaft (3d) into the opening (2e) at least up to the first predefined depth and subsequently actuating a runner or a sleeve (12) of the sensor (3) to slide in such a way on the supporting shaft (3d) that the struts (3b) are pivoted radially back towards the supporting shaft (3d).

8. Method according to claim 6, wherein step b) is carried out during step c), in such a way that while detaching the sensor flange (6) the second end of the struts (3b) fold over the supporting shaft (3d) along the longitudinal axis (x) of the supporting shaft (3d), wherein the struts (3b) point towards the inside of the fluid insulated apparatus (1).

9. Sensor (3) for detecting partial discharges in a fluid insulated apparatus (1) when it is installed in the latter according to the method of any of the claims 1 to 5, comprising a supporting shaft (3d), a sensor flange (6) and an antenna element, wherein the antenna element comprises a plurality of struts (3b), each of which has a first end and a second end and is attached at the first end to the supporting shaft (3d).

10. Sensor according to claim 9, further comprising a flexible conductive film or fabric (3a) connecting the struts (3b), wherein the film (3a) has at least an electrically conductive layer electrically connected to the supporting shaft (3d), wherein the film (3a) is stretchable into an extended position by moving the second ends of the struts (3b) away from the supporting shaft (3d) and is pulled into a retracted position by moving the second ends of the struts (3b) towards the supporting shaft (3d).

11. Sensor according to claim 9 or 10, further comprising a metallic center hub (3c) arranged concentrically around a longitudinal axis (x), wherein the electrically conductive layer is electrically connected to the supporting shaft (3d) by means of the metallic center hub (3c) and the struts (3d) are attached to the supporting shaft (3d) by means of the center hub (3c).

12. Sensor according to one of the claims 9 to 11, wherein the supporting shaft (3d) comprises electrically conductive material and is detachably attachable coaxially inside an insulating sleeve (6a) contained within the sensor flange (6), particularly wherein the insulating sleeve (6a) comprises or is made of Teflon or polyethylene.

13. Sensor according to any of the claims 9 to 12, further comprising an RF coaxial connector (4a), particularly a gas-tight type N RF connector, the connector center pin (5) of which is electrically connected to the supporting shaft (3d).

14. Sensor according to claim 13, further comprising a connector carrier (4), wherein the RF coaxial connector (4a) is attached to the connector carrier (4) which is detachably attachable to the sensor flange (6) so as to ensure a gas-tight hermetic seal for preventing leakage of the insulating fluid (2).

15. Sensor according to claim 14, comprising at least one sealing element (8), particularly an O-ring, for providing a gas tight hermetic seal between the sensor flange (6) and/or the connector carrier (4) and/or the supporting shaft (3d) in order to prevent leakage of the insulating fluid (2).

16. Sensor according to any one of the claims 9 to 15, wherein the supporting shaft (3d) has at least a first positioning element (7c) cooperating with at least a second positioning element (7a, 7b) of the sensor flange (6) in order to define at least a first and second insertion depth of the supporting shaft (3d) into the sensor flange (6).

17. Sensor according to claim 16, wherein one of the first or the second positioning element comprises at least one recess (7a, 7b) at the second insertion depth and the other positioning element comprises an elastic member (7c) snapping into the recess (7a, 7b) in order to fix the antenna element in an extended final measurement position.

18. Sensor according to any one of the claims 9 to 17, wherein the first ends of the struts (3b) are rigidly attached to the supporting shaft (3d).

19. Sensor according to any one of the claims 9 to 18, wherein the sensor flange (6) comprises a cavity (9), particularly a cylindrical cavity, for retaining the supporting shaft (3d) tensioned with the second ends of the struts (3b) inside the cavity (9) in the retracted position, or wherein the sensor (3) comprises a holder element, particularly a band or a ring, for keeping the struts (3b) tensioned in the retracted position, wherein the holder element is removable for releasing the tensioned struts (3b) which thereby snap into the extended position.

20. Sensor according to any one of the claims 9 to 19, comprising at least one tensioning element (11), wherein the tensioning element (11) is attached to the struts (3b) between their first and second end, and is attached to the supporting shaft (3d) by means of a runner or a sleeve (12) which is slidable along the supporting shaft (3d), particularly wherein an actuation element is provided for sliding the runner or sleeve (12).

21. Sensor according to any one of the claims 9 to 20, wherein the struts (3b) comprise or are made of poly-paraphenylene-terephthalamide.

22. Sensor according to any one of the claims 9 to 21, wherein the film (3a) comprises at least a layer of poly-paraphenylene-terephthalamide or biaxially-oriented polyethylene-terephthalate, particularly wherein the film (3a) comprises two of said layers of poly-paraphenylene-terephthalamide and the electrically conductive layer is arranged between the two layers.

23. Fluid insulated apparatus (1) with a removable sensor (3) according to one of the claims 9 to 22, in particular wherein the fluid insulated apparatus is fluid insulated switchgear, particularly gas insulated switchgear, or an oil insulated transformer.
